# EUROPÄISCHE PATENTSCHRIFT

(11) **EP 2 135 124 B1**
(45) Veröffentlichungstag und Bekanntmachung des Hinweises auf die Patenterteilung: **04.05.2011**
(21) Anmeldenummer: 08734419.8
(22) Anmeldetag: 19.03.2008
(51) Int. Cl.: G02B 7/02, G03F 7/20

(54) **OPTIKFASSUNG UND OPTISCHES BAUELEMENT MIT EINER DERARTIGEN OPTIKFASSUNG**
OPTICAL MOUNTING AND OPTICAL COMPONENT COMPRISING SAID TYPE OF OPTICAL MOUNTING
MONTURE OPTIQUE ET ÉLÉMENT OPTIQUE DOTÉ D'UNE MONTURE DE CE TYPE

(30) Priorität: 20.03.2007 DE 102007014155
(43) Veröffentlichungstag der Anmeldung: 23.12.2009
(73) Patentinhaber: JENOPTIK Optical Systems GmbH, 07745 Jena (DE)
(72) Erfinder: BORNSCHEIN, Marco, 07743 Jena (DE); SCHLETTERER, Thomas, 07646 Stadtroda (DE)
(74) Vertreter: Schaller, Renate
(86) Internationale Anmeldenummer: PCT/DE2008/000488
(87) Internationale Veröffentlichungsnummer: WO 2008/113341

(56) Entgegenhaltungen:
- JP-A- 2006 039 319
- US-A1- 2004 189 969
- US-B1- 6 175 451

## Beschreibung

Die Erfindung bezieht sich auf eine Optikfassung mit einer feststehenden Außenfassung und einem zur Aufnahme eines optischen Elementes ausgebildeten inneren Fassungsteil.
Die Optikfassung ist besonders für Projektionsobjektive geeignet, die während des Betriebes einer starken Erwärmung ausgesetzt sind.

Fassungen für Hochleistungsobjektive erfordern außer einem spannungsarmen Fassen der optischen Elemente Justiermöglichkeiten, mit denen das gefasste optische Element in axialer und radialer Richtung verstellt werden kann. Insbesondere ist während des Betriebes eines solchen Hochleistungsobjektives eine Justierung in einem weiten Bereich in axialer Richtung bedeutsam, durch die eine aufgrund hoher thermischer Belastungen erforderliche Fokusnachführung sowie eine Korrektur anderer Abbildungsfehler, wie z. B. Astigmatismus und Bildfeldwölbung durchgeführt werden kann.

Für ein spannungsarmes Fassen ist aus der DE 100 43 344 C2 ein elastischer Linsenträger mit radial elastischen Segmenten bekannt, die mit ihren freien Enden unter Vorspannung in eine Ringnut an der Umfangsfläche einer Linse eingreifen, wodurch die Linse spannungsarm, unmittelbar und ohne zusätzliche Mittel an ihrer Umfangsfläche gefasst werden kann.

Ein nur relativ geringer Verstellweg in Richtung der optischen Achse wird bei einer Baugruppe mit einem optischen Element und einer Fassung gemäß der DE 199 04 152 A1 dadurch erreicht, dass das optische Element durch ein membranartiges Fügeelement direkt oder indirekt mit der Fassung verbunden ist. Von Nachteil ist es außerdem, dass das membranartige Fügeelement direkt an dem optischen Element angreift.

Bei der DE 102 09 661 A1 stehen eine Innen- und eine Außenfassung über elastisch verformbare Bänder miteinander in Verbindung, wobei das Band jeweils über einen Befestigungsabschnitt mit der Innenfassung und der Außenfassung verbunden ist. Die Befestigungsabschnitte sind durch einen Bogenabschnitt und dazwischen liegende freie Anlagenteile miteinander verbunden.
Von Nachteil ist die Toleranzanfälligkeit des kompliziert aufgebauten Rollbandes, das zudem fertigungs- und montagetechnisch schwierig zu handhaben ist. Die Fassung besteht aus mehreren Komponenten und erfordert einen großen Bauraum in Richtung der optischen Achse.

Bekannt sind aus EP 1 014 139 A2, EP 1 677 133 A1 und US 6,259,571 B1 Optikfassungen mit jeweils einer Außenfassung und bezüglich dazu verstellbarer Innenfassung.
In EP 1 014 139 A2 werden durch Aktuatoren (8a, 8b, 9a, 9b) Druck- und Zugkräfte erzeugt, die einen Innnenring über eine radiale Kraft-Weg-Übersetzung gezielt deformieren.
Die gezielte Deformation des optischen Elementes ist dabei beabsichtigt, um Einfluss auf bestimmte Abbildungsfehler zu nehmen. Um das optische Element gezielt deformieren zu können, sind mindestens 4 Verbindungsstellen zwischen Außenring und Innenring notwendig, die durch Hebel gebildet werden. Nachteilig bei dieser Lösung ist jedoch, dass die Merkmale einer Isostasie verlassen wurden, die sich nachteilig im Spannungsverhalten äußern.
In EP 1 677 133 A1 ist eine Halteeinrichtung für mikrooptische Komponenten gezeigt, die aus einem mehrfach geschwungenem Halter besteht, welcher mit einem inneren Teil zur Aufnahme der mikrooptischen Komponente verbunden ist. Der in dieser Ausführung enthaltene mehrfach geschwungene Halter stellt jedoch keinen geschlossenen Außenring dar, sondern weist drei Unterbrechungen auf, was einen geschlossenen und damit steifen Außen- und Innenring nicht möglich macht und somit keine genaue Bewegung in definierten Freiheitsgraden garantiert, ohne dass das optische Element deformiert wird. Weiterhin ist die in dieser Druckschrift beschriebene Anordnung in Richtung der optischen Achse steif gegenüber den Richtungen quer zur optischen Achse ausgelegt.
Aus US 6,259,571 B1 ist ein feststehender Außenring und justierbarer Innenring mit optischem Element bekannt. Die Anordnung verwendet einen Kipphebel (5), der vorrangig dazu dient die Feinfühligkeit zu erhöhen, und die Richtung umzukehren. Der Verstellweg ist durch diese Anordnung jedoch vergleichsweise gering (Hebelgesetz).
Weiterhin ist in der WO 2006119970 A2 eine Lösung offenbart, bei der ein optisches Element 1 in mehreren Freiheitsgraden justiert werden kann. Dazu befindet sich bei dieser Ausführungsform zwischen dem feststehenden Außenring und dem justierbaren Innenring ein gezielt deformierbarer Zwischenring. Die Deformationen des Zwischenringes werden durch den Innenring abgegriffen und äußern sich am Innenring als Verschiebungen, die in 5 Freiheitsgraden möglich sind. Die Verschiebungen werden über die Deformation des Zwischenringes gesteuert, d. h. es handelt sich hierbei um einen Kraftaktuator, was wiederum zu ungewünschten Spannungen führen kann.

In US 6,175,451 B1 ist eine Vorrichtung und ein Verfahren zur Korrektur einer optischen Achse offenbart. Es ist eine Optikfassung mit einer feststehenden Außenfassung und einem gegenüber der Außenfassung verstellbaren und zur Aufnahme eines optischen Elementes ausgebildeten inneren Fassungsteil beschrieben, die dadurch gekennzeichnet ist, dass das innere Fassungsteil von koaxial zueinander, in einer Ebene liegenden federnden Ringscheiben umschlossen ist, die untereinander, mit dem inneren Fassungsteil und mit der Außenfassung über Biegebalken verbunden sind.

Aufgabe der Erfindung ist es, den Verstellweg in Richtung der optischen Achse des zu fassenden optischen Elementes zu vergrößern und dabei eine hohe Stabilität und Steifigkeit in einer zur optischen Achse senkrechten Richtung zu erreichen, wobei die aus dem Stand der Technik bekannten Nachteile weitestgehend zu vermeiden sind. Weiterhin sollen der Platzbedarf und der Fertigungs- und Montageaufwand möglichst gering gehalten werden.

Erfindungsgemäß wird diese Aufgabe bei einer Optikfassung mit einer feststehenden Außenfassung und einem gegenüber der Außenfassung verstellbaren und zur Aufnahme eines optischen Elementes ausgebildeten inneren Fassungsteil, dadurch gelöst, dass das innere Fassungsteil von koaxial zueinander, in einer Ebene liegenden federnden Ringscheiben umschlossen ist, die untereinander, mit dem inneren Fassungsteil und mit der Außenfassung über Biegebalken miteinander verbunden sind, wobei die Biegebalken so ausgebildet sind, dass sie in Richtung der optischen Achse eine geringe Steifigkeit und in allen anderen Richtungen eine große Steifigkeit aufweisen, wodurch eine Starrkörperbewegung des inneren Fassungsteils in Richtung der optischen Achse ermöglicht wird.
Werden die Biegebalken jeweils um 120° versetzt angeordnet, so dass eine Verbindung jeweils nur an drei Stellen besteht, werden Deformationen, die auf die Außenfassung z. B. durch den Montageprozess einwirken, stark geschwächt, bevor sie das optische Element erreichen können. Eine Übertragung wird somit weitgehend ausgeschlossen.
Dabei sind die Biegebalken so ausgebildet, dass sie in Richtung der optischen Achse eine geringe Steifigkeit aufweisen, um die Aktuatorkräfte gering zu halten. In allen anderen Richtungen, insbesondere quer zur optischen Achse, weisen die Biegebalken eine möglichst große Steifigkeit auf, um somit einer Dezentrierung des optischen Elements während der Verstellung entgegenzuwirken.

Erfindungsgemäß sind die Biegebalken nur an drei Stellen mit dem Außenring (Außenfassung) und dem Innenring (inneres Fassungsteil) verbunden, so dass Deformationen vom optischen Element weitestgehend fern gehalten werden.
Gekennzeichnet ist die Lösung durch einen geschlossenen und damit steifen Außen- und Innenring, die durch Biegebalken miteinander verbunden sind. Erst durch das Merkmal, dass Außen- und Innenring steif sind und die beabsichtigten Freiheitsgrade ausschließlich durch die Biegebalken erzeugt werden, ist eine eindeutige und zwangsfreie Starrkörperbewegung möglich.
Die Verbindung zwischen innerem Fassungsteil und Außenfassung wird somit über ein ineinander geschachteltes Federsystem gebildet, das aufgrund der großen Federwege große Verstellwege entlang der optischen Achse des zu fassenden optischen Elementes ermöglicht und trotzdem eine hohe Steifigkeit in einer zur optischen Achse senkrechten Richtung gewährleistet. Die Verschiebungen werden gegenüber dem Stand der Technik direkt von den Aktuatoren, ohne zusätzliche Kraftübersetzung eingeleitet.
Besonders vorteilhaft sind die Außenfassung, das innere Fassungsteil und die federnden Ringscheiben einstückig ausgebildet. Der Verstellmechanismus besteht somit aus federnden Ringscheiben, die ohne Richtungsumkehr der Erzeugung eines möglichst großen Verstellweges dienen. Zu diesem Zweck wurden auch mehrere Ringscheiben ineinander geschachtelt angeordnet. Durch die technisch einfache Fertigung des symmetrischen Aufbaus aus einem einzigen Teil lassen sich risikobehaftete mechanische Verbindungen wie Verschraubung oder andere zusätzliche Verbindungselemente sowie unterschiedliche Materialien vermeiden, wodurch eine hohe Langzeitstabilität erreicht wird. Außenfassung und inneres Fassungsteil weisen demzufolge keinerlei Spiel auf. Die Optikfassung benötigt einen geringen Platzbedarf.

Gegenstand der Erfindung ist ferner eine optische Baugruppe, bei der die Optikfassung mit einem darin gefassten optischen Element in einen rohrförmigen Träger eingepasst ist, der außerhalb des Wirkbereiches des optischen Elementes vorgesehene Stellmittel aufweist, die an dem inneren Fassungsteil angreifen. Außerdem sind an dem rohrförmigen Träger Messmittel zur Messung des Verstellweges in Richtung der optischen Achse des optischen Elementes angebracht.

Vorteilhaft sind als Stellmittel um jeweils 120° versetzt angeordnete Motoren vorgesehen, die über Spindeln am inneren Fassungsteil angreifen.
Hierdurch ist es insbesondere auch möglich, das innere Fassungsteil und damit das optische Element gegenüber der Außenfassung zu kippen, um Bildfehler zu minimieren.

In einer weiteren Ausgestaltung der Erfindung können als Stellmittel Piezoelemente vorgesehen sein, die über Hebel am inneren Fassungsteil angreifen.

Die Erfindung soll nachstehend anhand der schematischen Zeichnung näher erläutert werden. Es zeigen:
- Fig. 1: eine Draufsicht auf eine erfindungsgemäße Optikfassung
- Fig. 2: eine Schnittdarstellung durch die Optikfassung
- Fig. 3: die Optikfassung in einer perspektivischen Ansicht
- Fig. 4: eine optische Baugruppe, die eine Optikfassung gemäß Fig. 1 bis 3 enthält

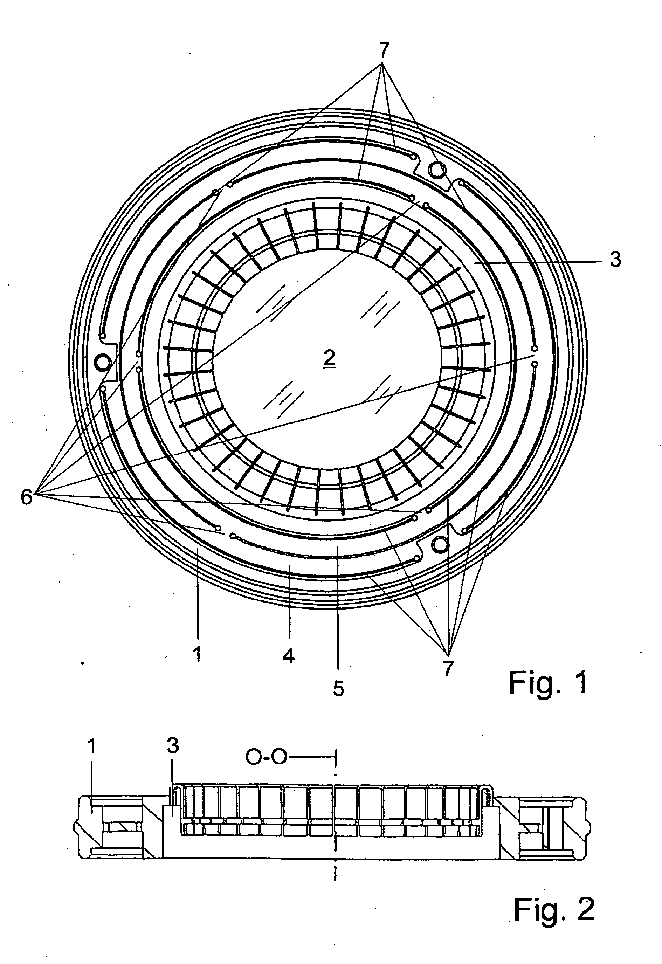

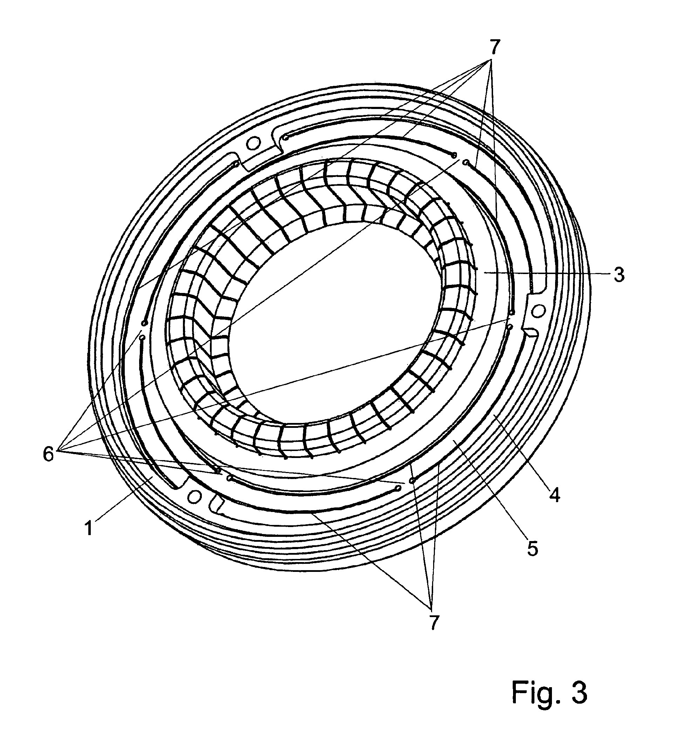

Die in Fig. 1 bis 3 gezeigte Optikfassung besteht aus einer feststehenden Außenfassung 1 und einem gegenüber der Außenfassung in Richtung der optischen Achse O-O eines zu fassenden optischen Elementes 2 verstellbaren inneren Fassungsteil 3. Die Verstellbarkeit des inneren Fassungsteiles 3 wird durch ein Blattfedersystem aus koaxial zueinander in einer Ebene angeordneten federnden Ringscheiben 4, 5 erreicht, die untereinander, mit dem inneren Fassungsteil 3 und mit der Außenfassung 1 durch jeweils um 120° versetzte Biegebalken 6 verbunden sind. Die federnden Ringscheiben 4, 5 bilden hintereinander geschaltete Blattfedern, die bis auf die Biegebalken 6 durch erodierte Schlitze 7 voneinander getrennt sind, wodurch ein großer Verschiebeweg in Richtung der optischen Achse O-O erreicht werden kann.

Das zur Aufnahme des optischen Elementes dienende innere Fassungsteil 3 ist entsprechend der DE 100 43 344 C2 ausgebildet, deren Offenbarung hier eingeschlossen ist.

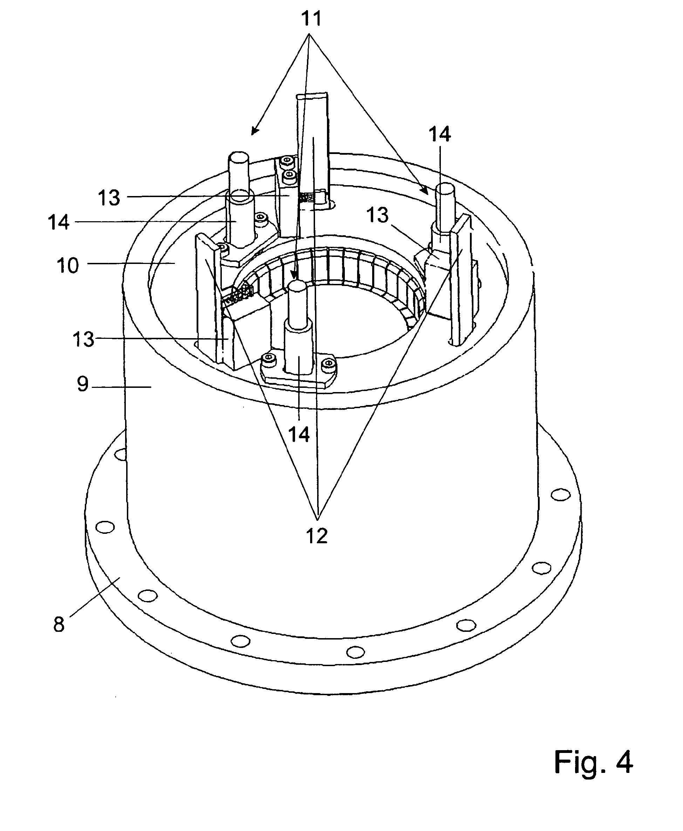

Die Optikfassung gemäß Fig. 1 bis 3 ist zur Verwendung in einer optischen Baugruppe geeignet, wie sie z. B. in Fig. 4 dargestellt ist. Die optische Baugruppe besteht aus einem, mit einem Halteflansch 8 ausgestatteten rohrförmigen Träger 9, der z. B. als Objektivrohr ausgebildet ist und in den die Optikfassung und eine kreisscheibenförmige Trägerplatte 10 eingesetzt sind, die den Wirkbereich des von der Optikfassung gefassten optischen Elementes 2, insbesondere eine optische Linse freilässt.

Die kreisscheibenförmige Trägerplatte 10 dient zur Aufnahme von Stellmitteln 11, die an dem inneren Fassungsteil 3 angreifen, um insbesondere thermisch bedingte Fokusänderungen durch Verstellung des inneren Fassungsteiles 3 in Richtung der optischen Achse O-O des gefassten optischen Elementes 2 ausgleichen zu können. Über ebenfalls an der kreisscheibenförmigen Trägerplatte 10 befestigte Messmittel, bestehend aus Linealen 12 als Maßverkörperungen und Encodern 13, ist der Verstellweg ermittelbar. Nicht dargestellt ist ein Fokussensor zur Feststellung einer Veränderung der Fokusebene sowie ein mit dem Fokussensor verbundenes Regelsystem, durch die eine erforderliche Fokusnachführung durch Verstellung des inneren Fassungsteiles 3 über die Stellmittel 11 bestimmt wird.

Als Stellmittel 11 sind bei der Ausführung gemäß Fig. 4 innerhalb des rohrförmigen Trägers 9 um jeweils 120° versetzt angeordnete Stellmotoren 14 auf der kreisscheibenförmigen Trägerplatte 10 befestigt, die über nicht dargestellte Spindeln durch die Trägerplatte 10 hindurch auf das innere Fassungsteil 3 einwirken.

Alternativ ist es auch möglich, Piezoaktoren zu verwenden, die über geeignete Hebel Druck auf das innere Fassungsteil 3 ausüben können.

## Patentansprüche

1. Optikfassung mit einer feststehenden Außenfassung und einem gegenüber der Außenfassung verstellbaren und zur Aufnahme eines optischen Elementes ausgebildeten inneren Fassungsteil, **dadurch gekennzeichnet, dass** das innere Fassungsteil (3) von koaxial zueinander, in einer Ebene liegenden federnden Ringscheiben (4, 5) umschlossen ist, die untereinander, mit dem inneren Fassungsteil (3) und mit der Außenfassung (1) über Biegebalken (6) miteinander verbunden sind, wobei die Biegebalken (6) jeweils an drei Stellen mit der Außenfassung und dem inneren Fassungsteil verbunden sind und die Biegebalken (6) so ausgebildet sind, dass sie in Richtung der optischen Achse eine geringe Steifigkeit und in allen anderen Richtungen eine große Steifigkeit aufweisen, wodurch eine Starrkörperbewegung des inneren Fassungsteils (3) in Richtung der optischen Achse ermöglicht wird.

2. Optikfassung nach Anspruch 1, **dadurch gekennzeichnet, dass** die Biegebalken (6) jeweils um 120° versetzt angeordnet sind.

3. Optikfassung nach mindestens einem der vorherigen Ansprüche, **dadurch gekennzeichnet, dass** die Außenfassung (11), das innere Fassungsteil (3) und die federnden Ringscheiben (4, 5) einstückig ausgebildet sind.

4. Optikfassung nach mindestens einem der vorherigen Ansprüche, **dadurch gekennzeichnet, dass** die federnden Ringscheiben (4, 5) ineinander geschachtelt angeordnet sind.

5. Optische Baugruppe, die in einer Optikfassung gemäß einem der Ansprüche 1 bis 4 ein optisches Element enthält, **dadurch gekennzeichnet, dass** die Optikfassung mit dem gefassten optischen Element (2) in einen rohrförmigen Träger (9) eingepasst ist, der außerhalb des Wirkbereiches des optischen Elementes (2) vorgesehene Stellmittel (11) aufweist, die an dem inneren Fassungsteil (3) angreifen, und dass an dem rohrförmigen Träger (9) Messmittel zur Messung des Verstellweges in Richtung der optischen Achse (O-O) des optischen Elementes (2) angebracht sind.

6. Optische Baugruppe nach Anspruch 5, **dadurch gekennzeichnet, dass** als Stellmittel (11) um jeweils 120° versetzt angeordnete Stellmotoren (14) vorgesehen sind, die über Spindeln am inneren Fassungsteil (3) angreifen.

7. Optische Baugruppe nach Anspruch 5, **dadurch gekennzeichnet, dass** als Stellmittel (11) Piezoelemente vorgesehen sind, die über Hebel am inneren Fassungsteil (3) angreifen.

## Claims

1. An optical mount comprising a stationary outer mount and an inner mount piece that is adjustable relative to the outer mount and designed to receive an optical element, **characterised in that** said inner mount piece (3) is enclosed by elastic annular disks (4, 5), which are disposed coaxially with respect to one another in one plane, and which are connected to one another, to the inner mount piece (3) and to the outer mount (1) via cantilevers (6), said cantilevers (6) being connected to the outer mount and to the inner mount piece at three points each and said cantilevers (6) being designed in such a manner that their rigidity in the direction of the optical axis is low and their rigidity in all other directions is high, thereby enabling a rigid body movement of the inner mount piece (3) in the direction of the optical axis.

2. Optical mount according to claim 1, **characterised in that** the cantilevers (6) are disposed so as to be staggered relative to one another by 120°.

3. Optical mount according to any one of the preceding claims, **characterised in that** the outer mount (11), the inner mount piece (3) and the elastic annular disks (4, 5) are integrally formed in one piece.

4. Optical mount according to any one of the preceding claims, **characterised in that** the elastic annular disks (4, 5) are nested one inside the other.

5. An optical assembly comprising an optical element in an optical mount according to any one of claims 1 to 4, **characterised in that** the optical mount with the mounted optical element (2) is fitted into a tubular carrier (9) having actuating means (11) disposed outside the effective range of the optical element (2), which actuating means act on the inner mount piece (3), and **in that** measuring means for measuring the adjustment path in the direction of the optical axis (O-O) of the optical element (2) are attached to the tubular carrier (9).

6. Optical assembly according to claim 5, **characterised in that** the actuating means (11) used are servomotors (14), which are disposed so as to be staggered relative to one another by 120° and which act on the inner mount piece (3) via spindles.

7. Optical assembly according to claim 5, **characterised in that** the actuating means (11) used are piezo elements which act on the inner mount piece (3) via levers.

## Revendications

1. Monture optique comprenant une monture extérieure fixe et une pièce de monture intérieure qui est réglable par rapport à ladite monture extérieure et dessinée pour recevoir un élément optique, **caractérisée en ce que** ladite pièce de monture intérieure (3) est entourée par des disques annulaires élastiques (4, 5), qui sont disposés coaxialement l'un par rapport à l'autre dans le même plan et reliés l'un à l'autre, ainsi qu'à la pièce de monture intérieure (3) et à la monture extérieure (1) au moyen de cantilevers (6), qui sont chacun reliés à la monture extérieure et à la pièce de monture intérieure en trois points et dessinés de manière à présenter une rigidité basse en direction de l'axe optique et une rigidité haute dans toutes les autres directions, permettant ainsi un mouvement de corps rigide de la pièce de monture intérieure (3) en direction de l'axe optique.

2. Monture optique selon la revendication 1, **caractérisée en ce que** les cantilevers (6) sont disposés avec un écart de 120° entre eux.

3. Monture optique selon l'une quelconque des revendications précédentes, **caractérisée en ce que** la monture extérieure (11), la pièce de monture intérieure (3) et les disques annulaires élastiques (4, 5) sont formés d'une seule pièce.

4. Monture optique selon l'une quelconque des revendications précédentes, **caractérisée en ce que** les disques annulaires élastiques (4, 5) sont imbriqués l'un dans l'autre.

5. Ensemble optique comprenant un élément optique dans une monture optique selon l'une quelconque des revendications 1 à 4, **caractérisé en ce que** ladite monture optique avec ledit élément optique (2) montée est emboitée dans un support tubulaire (9) qui présente des moyens d'actionnement (11) disposés hors de la zone active de l'élément optique (2) et agissant sur la pièce de monture intérieure (3), et **en ce que** des moyens de mesure pour mesurer la voie de déplacement en direction de l'axe optique (O-O) de l'élément optique (2) sont montés audit support tubulaire (9).

6. Ensemble optique selon la revendication 5, **caractérisé en ce que** l'on prévoit comme moyens d'actionnement (11) des servomoteurs (14) qui sont disposés de manière à présenter un écart de 120° entre eux et qui agissent sur la pièce de monture intérieure (3) au moyen de broches.

7. Ensemble optique selon la revendication 5, **caractérisé en ce que** l'on prévoit comme moyens d'actionnement (11) des éléments piézoélectriques qui agissent sur la pièce de monture intérieure (3) au moyen de leviers.
